(19) Europäisches Patentamt
European Patent Office
Office européen des brevets

(11) **EP 1 885 063 A1**

(12) **DEMANDE DE BREVET EUROPEEN**

(43) Date de publication:
**06.02.2008 Bulletin 2008/06**

(51) Int Cl.:
**H03H 9/54** *(2006.01)*

(21) Numéro de dépôt: **07368009.2**

(22) Date de dépôt: **27.07.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **28.07.2006 FR 0606919**

(71) Demandeur: **STMicroelectronics SA**
**92120 Montrouge (FR)**

(72) Inventeurs:
• **Cathelin, Andrea**
**38190 Laval (FR)**
• **Razafimandimby, Stephane**
**38000 Grenoble (FR)**
• **Kaiser, Andreas**
**59650 Villeneuve d'Ascq (FR)**

(74) Mandataire: **Schuffenecker, Thierry**
**120 Chemin de la Maure**
**06800 Cagnes sur Mer (FR)**

(54) **Circuit de filtrage doté de résonateurs accoustiques**

(57) La présente invention concerne un circuit de filtrage présentant une structure en treillis comportant une première et une seconde entrée (in1,in2) ainsi qu'une première et seconde sortie (o1,o2). Le circuit comporte deux impédances série Zs (10,20) et deux impédances parallèles (30,40) qui comportent chacune un résonateur acoustique (11) associé à deux composants inductif et capacitif (12,13) ajustable au moyen d'une première grandeur de commande (VC1). Les seconde et quatrième impédance (20,40) comportant chacune un résonateur acoustique (41) associé à deux composants inductif et capacitif (42,43) et ajustable au moyen d'une seconde grandeur de commande (VC2). Un circuit de commande génère des grandeurs VC1 et VC2 comportant simultanément un potentiel de mode commun et un potentiel de mode différentiel permettant l'apparition d'une première et d'une seconde bande passante exploitable pour la réalisation de deux filtres passe-bandes.

Fig. 4

## Description

## Domaine technique de l'invention

La présente invention concerne le domaine des télécommunications et notamment un circuit de filtrage doté de résonateurs acoustiques, notamment permettant un traitement multi-bande.

## Etat de la technique

L'emploi de résonateurs acoustiques se généralise dans les circuits de téléphonie mobile. D'une manière classique, on distingue les résonateurs de type SAW (*Surface Acoustic Resonator*) et ceux de type BAW (*Bulk Acoustic Resonator*). Dans les premiers, le résonateur acoustique est situé sur la surface d'un produit semi-conducteur tandis que, dans les seconds, il est disposé à l'intérieur d'un volume délimité entre une électrode inférieure et une électrode supérieure en sorte que l'onde acoustique se développe dans ce même volume.

L'utilisation de ces résonateurs acoustiques, et notamment les résonateurs de type BAW , se répand dans les circuits de filtrages RF en raison de leur grande efficacité.

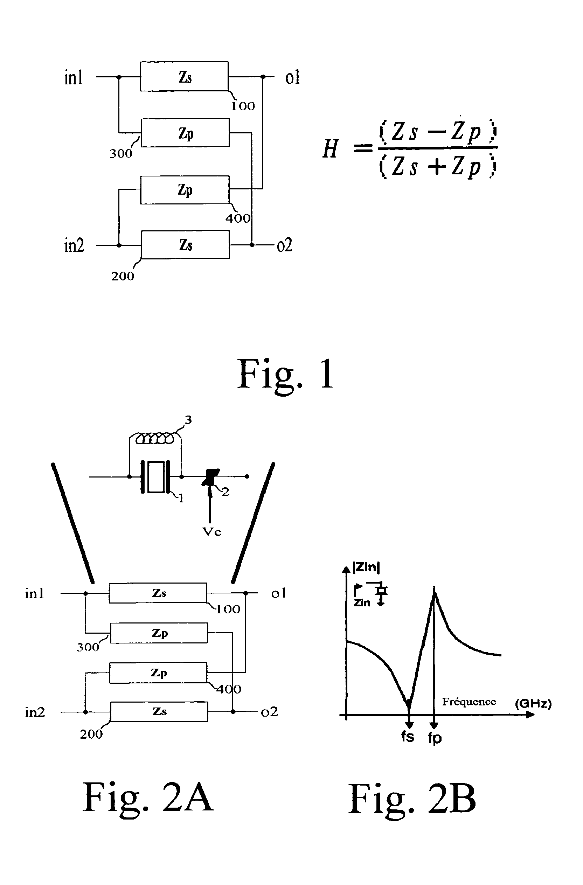

La figure 1 illustre un exemple connu de circuit de filtrage doté d'une structure en treillis, comportant une première et seconde impédance série Zs 100 et 200 et une troisième et quatrième impédance parallèle Zp 300 et 400. Chacune des impédances série Zs et parallèle Zp est réalisée au moyen d'un composant acoustique, ci-après désigné par l'expression *Composant Résonateur Réglable* (CRR) - tel que décrit dans la demande de brevet français n° 0315480 (ref 03-GR1-267) déposée le 29 Décembre 2003, comportant un résonateur acoustique de type BAW 1 et deux éléments compagnons, tel qu'un varactor 2 et une inductance 3.

Comme on le sait, le résonateur acoustique BAW est basé sur un milieu diélectrique disposé sur un élément réfléchissant tel un miroir de Bragg par exemple. On réalise un empilement de couches sur un substrat en silicium qui présente des propriétés acoustiques et des constantes diélectriques différentes. Un tel élément acoustique est connu dans la littérature anglo-saxonne sous l'appellation *Surface Mounted Resonator* (SMR). Alternativement, le résonateur pourra être de type *Film Bulk Acoustic Resonator* (FBAR), à savoir disposé au dessus d'une cavité pour permettre la réflexion des ondes acoustiques et éviter leur amortissement.

Le résonateur BAW présente deux fréquences de résonance très proches, respectivement fs (série) et fp (parallèle), comme illustré dans la figure 2B. Pour réaliser un Composant Résonateur Réglable à partir d'un résonateur BAW, on vient associer à ce dernier au moins deux éléments compagnons et, de préférence, un premier élément compagnon de type inductif (représenté par une inductance 3 dans la figure 2A), qui est variable ou non, actif ou passif que l'on vient faire résonner avec la capacité intrinsèque au résonateur (liée aux électrodes) au voisinage des fréquences de résonance et d'anti-résonance. Le second élément compagnon est généralement un élément de type capacitif (tel que représenté par exemple par le varactor 2 dans la figure 2A) et que l'on rend réglable en fonction d'une grandeur électrique, par exemple la grandeur $V_c$.

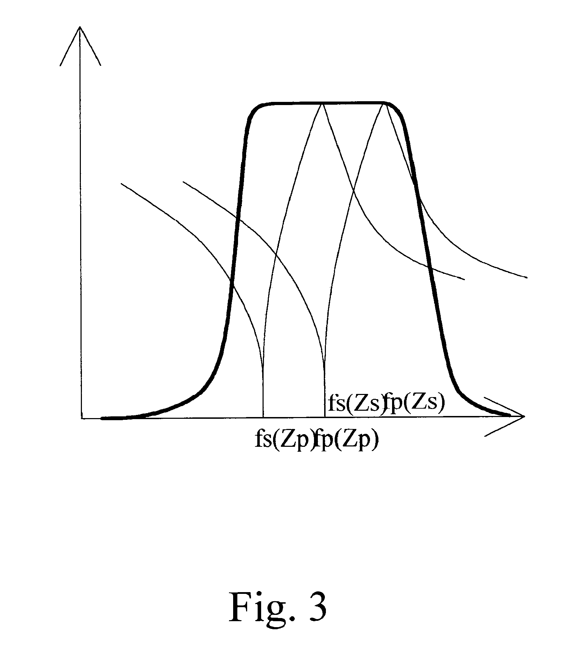

Dans la structure connue de la figure 2A, on vient commander la grandeur électrique $V_c$ de manière à venir ajuster les caractéristiques de deux impédances Zs et Zp comme cela est illustré dans la figure 3, en venant décaler légèrement les fréquences de résonance et d'anti-résonance de Zs et Zp permettant la réalisation d'un filtre passe-bande tel que représenté dans la figure 3. Ceci permet d'ajuster les fréquences caractéristiques des deux impédances Zs et Zp.

Les références suivantes illustrent l'état de la technique connue en ce qui concerne la conception de filtres basés sur des résonateurs de type BAW , sans composants passifs auxiliaires :

"High-Q Resonators using FBAR/SAW Technology and their Applications", M. Ueda et al., MTT-Symposium 2005

"Design Flow and Methodology on the Design of BAW components", par E. Schmidhammer et al., MTT-Symposium 2005

Les références suivantes illustrent l'état de la technique connue en ce qui concerne la conception de filtres comportant une cellule de régulation permettant d'ajuster la fréquence centrale du résonateur BAW :

"SiGe:C BiCMOS WCDMA Zero-IF RF Front-End Using An Above-IC BAW Filter", Carpentier J.F., Cathelin A., Tilhac C., et al., ISSCC 2005

"A Tunable Bandpass BAW-Filter Architecture and its Application to WCDMA Filter, J.F Carpentier at al., MTT-Symposyum 2005

« Nouvelle configuration de filtre RF accordable en fréquence utilisant des résonateurs BAW pour une chaîne de réception homodyne WCDMA » S. Razafimandimby et al., 6e Colloque TAISA 2005

"Bandpass BAW-Fi~r Architecture 'with Reduced Sensitivity to Process Vadations", C. Tilhac, S. Razafimandlmby et al., 2005 IEEJ Analog VLSI Workshop

Les références suivantes illustrent plus particulièrement la conception de filtres basés sur des résonateurs de type BAW , avec des composants passifs auxiliaires :

"Improved bulk wave resonator coupling coefficient for wide bandwidth filters", Lakin, K.M.; Belsick, J.; McDonald, J.F.; McCanon, K.T.;Ultrasonics Symposium, 2001 IEEE.

"A Film Bulk Acoustic Resonator (FBAR) Duplexer for USPCS Handset Applications", P. Bradley, et al., MTT-Symposium, 2001

Les développements les plus récents en matière de télécommunication mobile ont fait apparaître de nouveaux besoins.

Si l'on envisage la réalisation d'un résonateur acoustique de type BAW avec une fréquence de travail plus faible, par exemple de l'ordre de 1 GHz, il faut en principe réaliser une couche piézo-électrique présentant une épaisseur plus importante, opération qui reste délicate pour les procédés de fabrication connus.

Il faut souligner l'accroissement de la demande des consommateurs pour des téléphone multi-bandes. Pour le réseau GSM, on rappelle que la fréquence de travail est de 850 MHz aux Etats-Unis, alors qu'elle est de 900 Mhz pour l'Europe. Si l'on envisage la norme européenne DCS, il convient de fonctionner à une fréquence de 1800 MHz tandis que la norme américaine PCS impose de fonctionner à 1900 MHz. Comme on le voit, si l'on prétend réaliser un téléphone multi-bande qui est capable de fonctionner dans plusieurs régions du globe, il est nécessaire de prévoir, soit plusieurs filtres très sélectifs adressant chacun une bande et les multiplexeurs, soit des filtres RF disposant de bandes de fréquences différentes.

Classiquement, on réalise un téléphone multi-bande en juxtaposant des circuits de filtrages spécifiques - dotés chacun d'un résonateur acoustique distinct - fonctionnant à une bande précise et des circuits de réception spécifiques.

Cette technique connue, qui présente l'avantage de la simplicité de mise en oeuvre, est cependant fort onéreuse puisqu'il convient d'embarquer plusieurs structures de résonateurs BAW dans un même téléphone.

Il est donc souhaitable de pouvoir réaliser un circuit de filtrage qui permette de traiter indifféremment plusieurs bandes de fréquences, et ce avec les mêmes résonateurs acoustiques.

Tel est le but à atteindre par la présente invention.

**Résumé de l'invention**

La présente invention a pour objet la réalisation d'un filtre doté de résonateurs acoustiques permettant une fréquence de travail de l'ordre de 1 GHz, et ce en conservant une technologie de fabrication de résonateurs conçus pour une fréquence de l'ordre de 2 GHz.

Un autre but de l'invention consiste à permettre l'utilisation d'un résonateur de type BAW originellement conçu pour une fréquence de l'ordre de 2 GHz dans une gamme de fréquence de valeur moitié de la fréquence originelle.

C'est un troisième but de la présente invention que de permettre la réalisation d'un circuit de filtrage RF , dotés de résonateurs acoustiques, permettant de traiter plusieurs bandes de fréquences distinctes.

L'invention réalise ces buts au moyen d'un circuit de filtrage présentant une structure en treillis comportant une première et une seconde entrée (in1, in2) ainsi qu'une première et seconde sortie (o1, o2). Le circuit comporte deux impédances série Zs (10, 20) et deux impédances parallèles (30, 40) qui comportent chacune un résonateur acoustique (11) associé à deux composants inductif et capacitif (12, 13) ajustable au moyen d'une première grandeur de commande (VC1). Les seconde et quatrième impédance (20, 40) comportant chacune un résonateur acoustique (41) associé à deux composants inductif et capacitif (42, 43) et ajustable au moyen d'une seconde grandeur de commande (VC2). Un circuit de commande génère des grandeurs VC1 et VC2 comportant simultanément un potentiel de mode commun et un potentiel de mode différentiel (Vx) permettant l'apparition d'une première et d'une seconde bande passante exploitable pour la réalisation de deux filtres passe-bandes.....

En venant commander judicieusement le potentiel de mode différentiel (Vx), on peut ainsi obtenir un filtrage passe-bande dans une gamme de fréquence égale à une valeur de l'ordre de 50% de la valeur nominale du résonateur BAW, venant ainsi étendre considérablement les possibilités de filtrage, en plus de la fonction de filtrage principal.

On peut par ailleurs réaliser un circuit de filtrage multi-bande utilisant un même jeu de résonateurs BAW, ce qui permet d'en réduire considérablement le coût de fabrication.

Dans un mode de réalisation préféré, chacune des impédances au sein de la structure en treillis comporte un résonateur de type BAW monté en parallèle avec une inductance et l'ensemble étant en série avec un varactor ajustable par un potentiel de commande (VC1, VC2).

Alternativement, on réalise chacune des impédances au moyen d'une structure duale dans laquelle chacune des impédances comporte un résonateur BAW en série avec une inductance, et l'ensemble étant en parallèle avec un varactor ajustable par un potentiel de commande.

De préférence, le circuit de filtrage permet la réalisation d'un filtrage passe-bande ayant une première bande de fréquence correspondant à la bande GSM et une seconde bande de fréquence correspondant au standard DCS.

Dans un autre mode de réalisation particulier, le circuit de filtrage permet la réalisation d'un filtrage passe-bande ayant une première bande de fréquence correspondant à la bande WCDMA à 850 Mhz et une seconde bande de fréquence correspondant au standard WCDMA à 2.14 GHz.

Dans un autre mode de réalisation, le circuit de filtrage réalise une première bande passante correspondant au standard GPS à 1.5 GHz et une seconde bande passante correspondant au standard Bluetooth à 2.45 GHz .

L'invention est particulièrement adapté à la réalisation d'un circuit récepteur pour un téléphone mobile multi-bande.

**Description des dessins**

D'autres caractéristiques, but et avantages de l'invention apparaîtront à la lecture de la description et des dessins ci-après, donnés uniquement à titre d'exemples non limitatifs. Sur les dessins annexés :

La figure 1 rappelle la structure d'un filtre en treillis comportant deux impédances série Zs 100 et 200 et deux impédances parallèles Zp 300 et 400, ainsi que la formule de la fonction de transfert H d'un tel filtre

La figure 2A illustre une réalisation connue d'un filtre en treillis comportant, pour chacune des impédances série et parallèle, un résonateur BAW associés à deux composants compagnons, choisis de manière à constituer un filtre passe bande.

La figure 2B rappelle la courbe caractéristique d'un résonateur acoustique de type BAW, mettant en évidence une fréquence de résonance et la fréquence d'anti-résonance.

La figure 3 illustre une fonction de transfert de type passe-bande obtenue au moyen du circuit de la figure 2A.

La figure 4 illustre une structure de filtre en treillis conforme à la présente invention permettant un filtrage multi-bande.

La figure 5 illustre un mode de réalisation d'un filtre dual-bande.

La figure 6 illustre un mode de réalisation particulier de l'invention permettant la réalisation d'un circuit de filtrage pour un canal dans la bande GSM et toute la bande DCS.

La figure 7 illustre plus particulièrement le détail de la première bande passante (GSM) du circuit de filtrage de la figure 6.

La figure 8 illustre plus particulièrement le détail de la seconde bande passante (DCS) du circuit de filtrage de la figure 6.

La figure 9 illustre un mode de réalisation de la présente invention comportant une cascade de deux quadripôles en treillis.

**Description d'un mode de réalisation préféré**

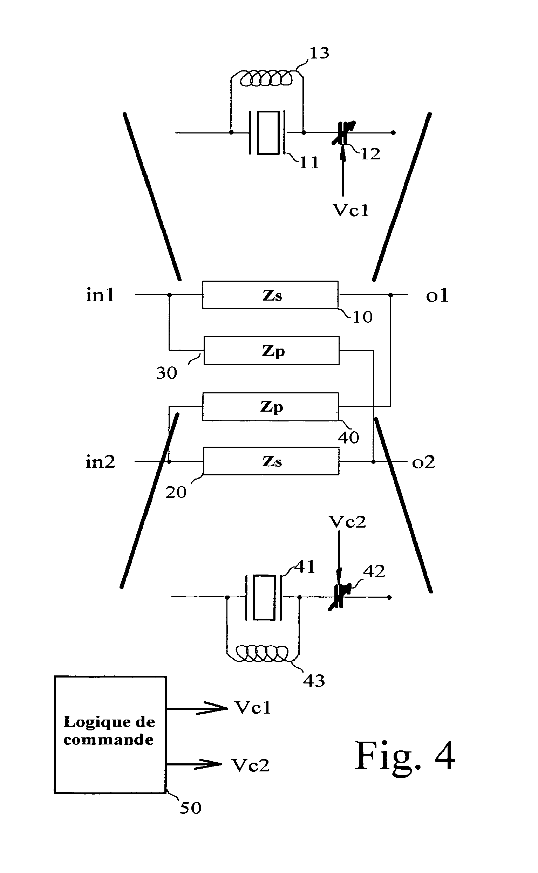

En référence à la figure 4, on décrit à présent un circuit de filtrage multi-bande permettant d'étendre la gamme de fréquence de fonctionnement des résonateurs BAW conçus pour une technologie donnée, par exemple adaptée à une fréquence de l'ordre de 2 GHz, et qui permettra un fonctionnement à une fréquence de l'ordre de la moitié, soit 1 GHz.

Comme on le voit dans la figure 4, le circuit de filtrage selon l'invention présente la structure d'un quadripôle en treillis comportant une première et une seconde entrée IN1 et IN2 et une première et seconde sortie O1 et O2. Le circuit comporte une première impédance série Zs 10 connectée entre l'entrée IN1 et la sortie O1 et une seconde impédance série Zs 20 connectée entre l'entrée IN2 et la sortie 02. En outre, le circuit comporte une troisième impédance Zp connectée en parallèle entre l'entrée IN1 et la sortie 02, ainsi qu'une quatrième impédance Zp connectée entre l'entrée IN2 et la sortie O1.

Suivant la présente invention, chacune des impédances série Zs 10 et 20 est caractérisée par au moins une première et une seconde fréquence de résonance, respectivement f1 et f2. Comme on le sait, une fréquence de résonance se manifeste par une valeur minimale de l'impédance Zs (idéalement nulle).

De la même manière, chacune des impédances Zp 30 et 40 est caractérisée par une troisième et quatrième fréquences de résonance, respectivement f3 et f4.

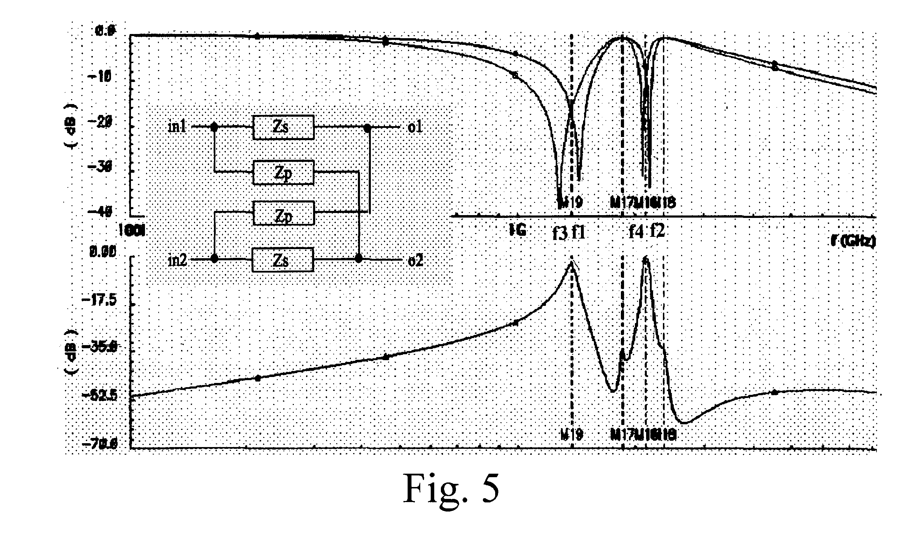

Pour réaliser le circuit de filtrage selon la présente invention, on s'arrange pour choisir les fréquences de résonances f1 et f3 soient dans un même voisinage, comme cela est représenté dans la figure 5 et, de la même manière, les seconde et quatrième fréquences de résonance f2 et f4 soient dans un même voisinage.

En choisissant des impédances présentant ces caractéristiques, on a constaté que l'on parvenait à obtenir, dans les deux voisinages considérés un maximum de transmission puisque l'on avait simultanément :

- un même module pour Zs et Zp et
- un déphasage de 180 degrés pour les deux impédances, ce qui assure alors un phénomène constructif dans la formule de la fonction de transfert H rappelée dans la figure 1.

On a constaté qu'en montant des résonateurs de type BAW, associés à deux composants compagnons commandés de manière judicieuse de manière à remplir les conditions exprimées précédemment, on pouvait alors faire apparaître au moins une seconde fréquence de résonance à une valeur très inférieure de celle de la fréquence de résonance classiquement exploitée pour le résonateur BAW, par exemple la moitié de cette valeur.

La figure 4 montre plus particulièrement un exemple d'implémentation des impédances Zs et Zp. On voit que l'impédance Zs se compose d'un résonateur BAW 11 , auquel on associe, en parallèle, une inductance 13 que l'on vient ajuster pour entrer en résonance avec la capacité parallèle de ce même résonateur, proche de la fréquence notée $f_p$, ou dans un voisinage de cette même fréquence. On vient alors travailler sur la fréquence série du résonateur et ce au moyen de l'élément de réglage capacitif que représente le varactor 12, commandé par une première grandeur, à savoir une première tension de commande Vc1.

De la même manière, on réalise l'impédance Zp au moyen d'un résonateur BAW 41 auquel on associe , en parallèle, une inductance 43 et un élément de réglage capacitif 42 qui est également un varactor commandé par une seconde grandeur, à savoir une tension de commande Vc2.

Un circuit de commande 50 permet de générer les première et seconde tensions de commande Vc1 et Vc2 de manière à créer un potentiel de mode différentiel Vx qui vient s'ajouter au potentiel de mode commun et ramener alors au moins une seconde fréquence de résonance au sein des impédances Zs et Zp dans une gamme directement exploitable pour réaliser un circuit de filtrage passe-bande opérant à une fréquence moitié, ie une fréquence de l'ordre de 1 GHz.

Il est à noter que la réalisation illustrée est une réalisation qui est conçue pour permettre le travail sur la fréquence série du résonateur. Comme cela est connu, on pourra employer une structure duale dans laquelle on vient travailler sur la fréquence parallèle, et ce en venant disposer en série avec le résonateur BAW et, en parallèle sur les deux éléments en série, un élément de réglage capacitif tel qu'un varactor ajusté par une tension de commande Vc1 ou Vc2 (selon que l'on considère la réalisation de l'impédance Zs ou Zp). De telles modifications sont à la portée d'un homme du métier et, par conséquent, ne seront pas détaillées plus avant.

La figure 5 illustre les caractéristiques que l'on peut obtenir sur les impédances Zs et Zp réalisées au moyen des composants résonateurs variables - convenablement commandés par les tensions Vc1 et Vc2 générées par la logique de commande 50,. On voit en effet apparaître (sur la partie supérieure de la figure 5), pour chacune des impédances Zp et Zs, une seconde fréquence de résonance et l'on constate également que les fréquences de résonances sont, deux par deux, dans un même voisinage.

Comme on le constate alors sur la partie inférieure de la figure, on peut alors tirer avantage du phénomène constructif lié à la fonction de transfert H de la figure 1, et réaliser un passe-bande fonctionnant à une fréquence moitié de la fréquence originellement prévue pour le résonateur BAW.

Cet espacement considérable - de l'ordre de 1 GHz - entre les bandes passantes que l'on peut réaliser au moyen d'un même jeu de résonateurs BAW permet à présent d'envisager des bandes passantes diverses correspondant à autant d'applications spécifiques en téléphonie mobile (mais point exclusivement).

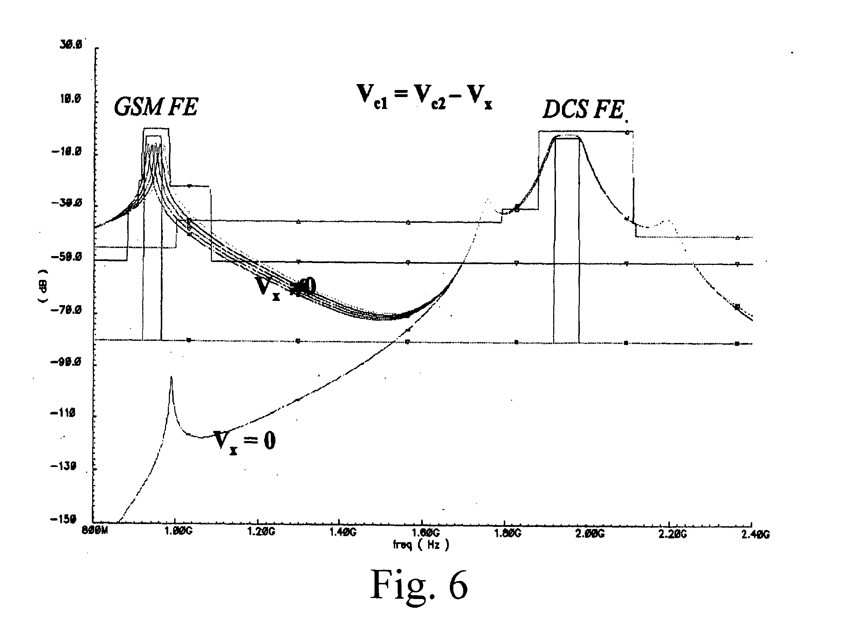

La figure 6 montre ainsi un mode de réalisation spécifique d'un circuit de filtrage en treillis permettant un fonctionnement suivant un canal du mode GSM (à 850 MHz) mais également suivant le standard américain DCS.

Comme on le voit, on vient commander les varactors des impédances Zs et Zp de manière à injecter, d'une part, une tension de mode commun (par exemple VC1), et un potentiel de mode différentiel Vx tel que :

$$Vx = Vc2 - Vc1$$

Lorsque Vx = 0, on constate que le circuit de filtrage de la figure 4 ne comporte, dans la zone exploitable, qu'une seule bande passante située autour de 2 GHz et permettant la filtrage dans la bande DCS. Sur l'axe des fréquences, située à une valeur de l'ordre de 50% de la fréquence de résonateur, on voit apparaître un « pic » qui se manifeste à une valeur de l'ordre de -90 dB, c'est à dire qui n'est pas mesurable et, par conséquent, pas directement exploitable. Dans cette configuration où Vx = 0, le circuit de filtrage de la figure 4 réalise une fonction passe bande unique, telle que celle connue classiquement.

En revanche, et c'est un des effets surprenants de la présente invention, on constate, dès lors que l'on vient introduire un potentiel de mode différentiel Vx qui présente une valeur suffisante, qu'apparaît une remontée du « pic » mentionné précédemment dans une zone exploitable, c'est à dire permettant d'envisager la création d'une seconde fonction de filtrage passe-bande située dans une gamme de fréquence de l'ordre de la moitié de la valeur précédente.

Cette seconde bande passante tombe dans la gamme GSM.

Comme on le voit, on peut dès lors réaliser un circuit de filtrage composé d'un jeu de résonateurs BAW qui puisse servir à plusieurs bandes de fréquences.

On constate ainsi, et cela est particulièrement avantageux, que l'on peut ainsi exploiter un composant BAW prédéterminé à une fréquence bien inférieure à celle que l'on utilise classiquement.

On observe ainsi, et c'est déjà un premier avantage essentiel de la présente invention, que l'on peut dès lors envisager le fonctionnement des résonateurs BAW répondant à une technologie de fabrication spécifique dans une gamme de travail bien plus vaste. On peut dès lors, limiter les coûts de fabrication puisqu'il n'est pas nécessaire d'envisager de revoir le procédé de fabrication des résonateurs BAW pour étendre leurs caractéristiques à des valeurs non encore exploitées aujourd'hui.

En second lieu, et il s'agit d'un avantage particulièrement décisif, on peut à présent exploiter directement, et ce en venant régler convenablement le mode commun et le mode différentiel des potentiels Vc1 et Vc2 , les deux bandes passantes offertes par le même circuit de filtrage en treillis.

Comme cela est illustré dans la figure 6, on peut ainsi réaliser un unique circuit de filtrage répondant à la norme GSM (opérant à 850 Mhz) et à la norme DCS fonctionnant à 2 GHz .

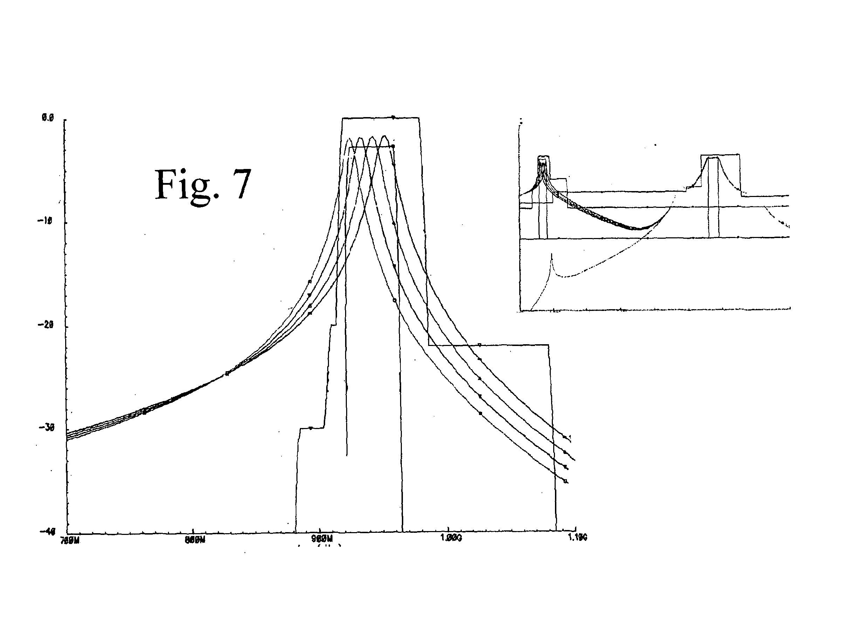

La figure 7 illustre plus particulièrement le détail de la bande GSM où l'on voit , de manière surprenante, que l'on peut même, en venant commander convenablement les tensions de commande Vc1 et Vc2, obtenir une sélection directe du canal GSM souhaité et ce en raison du caractère particulièrement raide de la bande de fréquence.

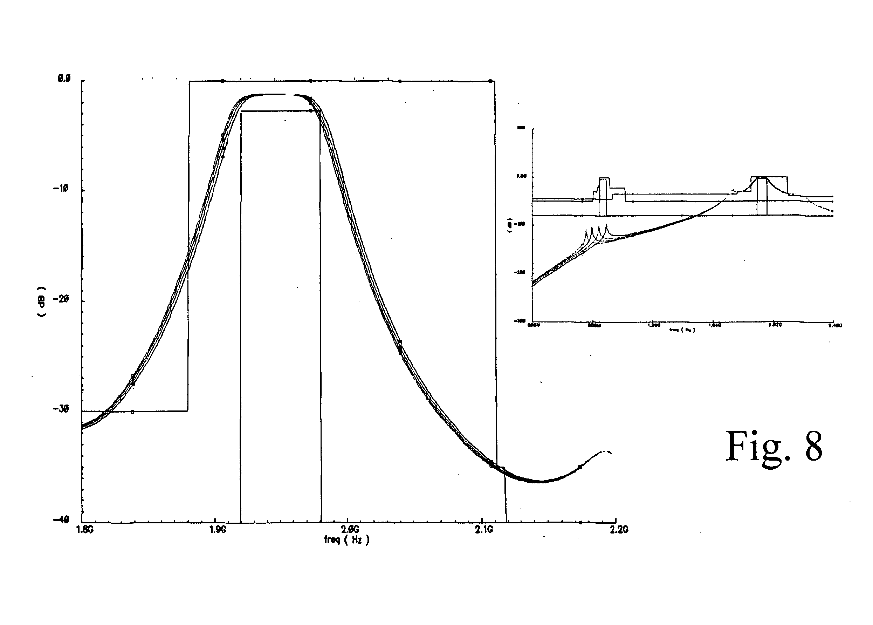

La figure 8 illustre plus particulièrement le détail de la bande DCS correspondant au deuxième voisinage des secondes et quatrièmes fréquences de résonances f2 et f4 des impédances Zs et Zp. On voit que l'on réalise de cette manière, très simplement, un filtre passe bande dont les caractéristiques peuvent être finement ajustées de manière à entrer dans le gabarit imposé par la norme.

L'invention peut permettre la réalisation d'une grande variété de circuits de filtrage. Ainsi, un second mode de réalisation permet de réaliser un filtrage répondant simultanément aux normes WCDMA à 850 Mhz et WCDMA à 2.14 GHz.

Un troisième mode de réalisation permet également de réaliser un unique circuit de filtrage permettant le traitement BLUETOOTH à 2.45 GHz et GPS à 1.5 GHz.

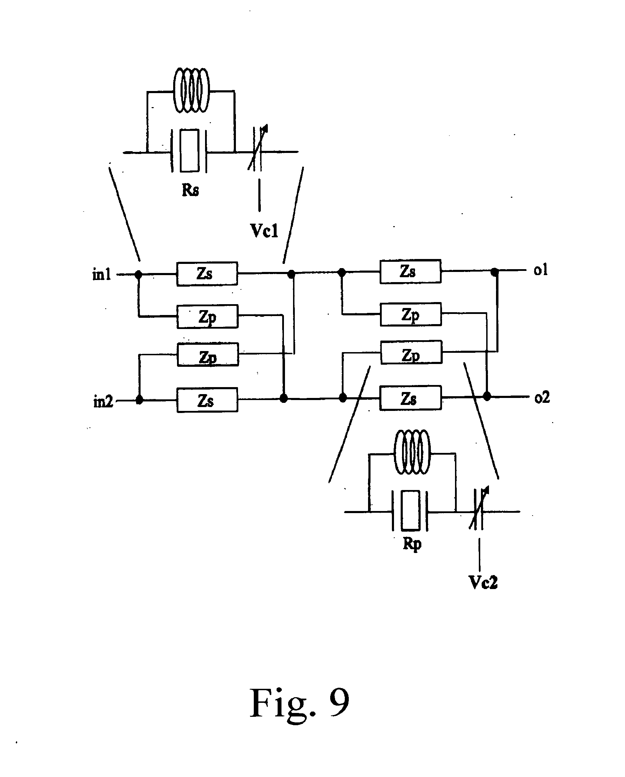

La figure 9 est un autre mode de réalisation d'un circuit de filtrage conforme à la présente invention dans lequel on vient associer, en cascade, deux structures de filtrages en treillis telles que définies précédemment. Clairement, un homme du métier peut adapter le circuit qui vient d'être décrit à toutes les applications envisagées, qu'elles portent sur de la téléphonie de première, de seconde génération, voire pour des circuits de transmission et/ou de réception quelconques.

**Revendications**

1. Circuit de filtrage présentant une structure en treillis comportant une première et une seconde entrée (in1, in2) et une première et seconde sortie (o1, o2), ledit circuit comportant :

   - une première impédance (10) série Zs connectée entre ladite première entrée (in1) et ladite première sortie (o1) ;
   - une seconde impédance (20) série Zs connectée entre ladite seconde entrée (in2) et ladite seconde sortie (o2);
   - une troisième impédance (30) parallèle Zp connectée entre ladite première entrée (in1) et ladite seconde sortie (o2) ;
   - une quatrième impédance (40) parallèle Zp connectée entre ladite seconde entrée (in2) et ladite première sortie (o1) ;

   lesdites première, et troisième impédances (10, 30) comportant chacune un résonateur acoustique (11) associé à deux composants inductif et capacitif (12, 13) et ajustable au moyen d'une première grandeur de commande (VC1),

   lesdites seconde et quatrième impédance (20, 40) comportant chacune un résonateur acoustique (41) associé à deux composants inductif et capacitif (42, 43) et ajustable au moyen d'une seconde grandeur de commande (VC2) ;

   - un circuit (50) destiné à générer lesdites première et seconde grandeurs de commande (VC1) et (VC2) **caractérisés par** un potentiel de mode commun et un potentiel de mode différentiel (Vx) permettant l'apparition d'une première bande passante et d'au moins une seconde bande passante.

2. Circuit de filtrage selon la revendication 1 **caractérisé en ce que** la seconde bande passante est située à une fréquence de l'ordre de la moitié de la fréquence de ladite première bande passante.

3. Circuit de filtrage selon l'une des revendications précédentes, **caractérisé en ce que** chacune desdites première, seconde, troisième et quatrième impédances comporte un résonateur de type BAW (11, 41) en parallèle avec une inductance (13, 43) et l'ensemble étant en série avec un varactor (12, 42) ajustable par un potentiel de commande (VC1, VC2).

4. Circuit de filtrage selon la revendication 1 ou 2 **caractérisé en ce que** chacune desdites première, seconde, troisième et quatrième impédances comporte un résonateur de type BAW (11, 41) en série avec une inductance (13, 43) et l'ensemble étant en parallèle avec un varactor (12, 42) ajustable par un potentiel de commande (VC1, VC2).

5. Circuit de filtrage selon l'une des revendications précédentes dans lequel ladite première bande passante correspond à une partie de la bande GSM et ladite seconde bande passante correspond à la bande DCS.

6. Circuit de filtrage selon la revendication 5 **caractérisé en ce que** lesdites première et seconde grandeur de commande (VC1, VC2) sont générées de manière à permettre la sélection du canal GSM au sein de la première bande passante.

7. Circuit de filtrage selon l'une des revendications 1 à 4 **caractérisé en ce que** ladite première bande passante correspond à une partie de la bande WCDMA à 850 MHz et **en ce que** ladite seconde bande passante correspond au standard WCDMA à 2.14 GHz.

**8.** Circuit de filtrage selon l'une des revendications 1 à 4 **caractérisé en ce que** ladite première bande passante correspond au standard GPS à 1.5 GHz et **en ce que** ladite seconde bande passante correspond au standard bluetooth à 2.45 GHz.

**9.** Téléphone mobile comportant un émetteur ou un récepteur doté d'un circuit de filtrage présentant une structure en treillis comportant une première et une seconde entrée (in1, in2) et une première et seconde sortie (o1, o2), ledit circuit comportant :

- une première impédance (10) série Zs connectée entre ladite première entrée (in1) et ladite première sortie (o1) ;
- une seconde impédance (20) série Zs connectée entre ladite seconde entrée (in2) et ladite seconde sortie (o2);
- une troisième impédance (30) parallèle Zp connectée entre ladite première entrée (in1) et ladite seconde sortie (o2) ;
- une quatrième impédance (40) parallèle Zp connectée entre ladite seconde entrée (in2) et ladite première sortie (o1) ;

lesdites première, et troisième impédances (10, 30) comportant chacune un résonateur acoustique (11) associé à deux composants inductif et capacitif (12, 13) et ajustable au moyen d'une première grandeur de commande (VC1),
lesdites seconde et quatrième impédance (20, 40) comportant chacune un résonateur acoustique (41) associé à deux composants inductif et capacitif (42, 43) et ajustable au moyen d'une seconde grandeur de commande (VC2) ;

- un circuit (50) destiné à générer lesdites première et seconde grandeurs de commande (VC1) et (VC2) **caractérisées par** un potentiel de mode commun et un potentiel de mode différentiel (Vx) permettant l'apparition d'une première bande passante et d'au moins une seconde bande passante.

**10.** Circuit de filtrage selon l'une des revendications précédentes, **caractérisé en ce que** chacune desdites première, seconde, troisième et quatrième impédances comporte un résonateur de type BAW (11, 41) en série avec une inductance (13, 43) et l'ensemble étant en parallèle avec un varactor (12, 42) ajustable par un potentiel de commande (VC1, VC2).

$$H = \frac{(Zs - Zp)}{(Zs + Zp)}$$

Fig. 1

Fig. 2A

Fig. 2B

Fig. 3

Fig. 4

Fig. 5

EP 1 885 063 A1

Fig. 6

Fig. 7

Fig. 8

Fig. 9

**Office européen**
**des brevets**

**RAPPORT DE RECHERCHE EUROPEENNE**

Numéro de la demande

EP 07 36 8009

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| D,Y | CARPENTIER J ET AL: "A Tunable Bandpass BAW-Filter Architecture and Its Application to WCDMA filter" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12 juin 2005 (2005-06-12), pages 221-224, XP010844727 ISBN: 0-7803-8846-1 * le document en entier * ----- | 1-9 | INV. H03H9/54 |
| Y | US 2005/212612 A1 (KAWAKUBO TAKASHI [JP] ET AL) 29 septembre 2005 (2005-09-29) * alinéa [0094] - alinéa [0099]; figures 14,15a,15b * ----- | 1-9 | |

DOMAINES TECHNIQUES RECHERCHES (IPC)

H03H

Le présent rapport a été établi pour toutes les revendications

| Lieu de la recherche | Date d'achèvement de la recherche | Examinateur |
|---|---|---|
| La Haye | 31 octobre 2007 | Lecoutre, Renaud |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 07 36 8009

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-10-2007

| Document brevet cité au rapport de recherche | Date de publication | Membre(s) de la famille de brevet(s) | Date de publication |
|---|---|---|---|
| US 2005212612 A1 | 29-09-2005 | CN 1649265 A<br>JP 2005217852 A | 03-08-2005<br>11-08-2005 |

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0315480

**Littérature non-brevet citée dans la description**

- **M. UEDA et al.** High-Q Resonators using FBAR/SAW Technology and their Applications. *MTT-Symposium,* 2005
- **E. SCHMIDHAMMER et al.** Design Flow and Methodology on the Design of BAW components. *MTT-Symposium,* 2005
- **CARPENTIER J.F ; CATHELIN A ; TILHAC C et al.** SiGe:C BiCMOS WCDMA Zero-IF RF Front-End Using An Above-IC BAW Filter. *ISSCC,* 2005
- **J.F CARPENTIER.** A Tunable Bandpass BAW-Filter Architecture and its Application to WCDMA Filter. *MTT-Symposyum,* 2005
- **S. RAZAFIMANDIMBY et al.** Nouvelle configuration de filtre RF accordable en fréquence utilisant des résonateurs BAW pour une chaîne de réception homodyne WCDMA. *6e Colloque TAISA,* 2005
- **C. TILHAC ; S. RAZAFIMANDLMBY et al.** Bandpass BAW-Fi~r Architecture 'with Reduced Sensitivity to Process Vadations. *IEEJ Analog VLSI Workshop,* 2005
- Improved bulk wave resonator coupling coefficient for wide bandwidth filters. **LAKIN, K.M ; BELSICK, J ; MCDONALD, J.F ; MCCANON, K.T.** Ultrasonics Symposium. IEEE, 2001
- **P. BRADLEY et al.** A Film Bulk Acoustic Resonator (FBAR) Duplexer for USPCS Handset Applications. *MTT-Symposium,* 2001